(19) Europäisches Patentamt
European Patent Office
Office européen des brevets

(11) **EP 2 790 028 B1**

(12) **EUROPEAN PATENT SPECIFICATION**

(45) Date of publication and mention
of the grant of the patent:
**02.01.2019 Bulletin 2019/01**

(51) Int Cl.:
***G01R 31/34*** *(2006.01)*      ***H02P 29/02*** *(2016.01)*

(21) Application number: **14163444.4**

(22) Date of filing: **03.04.2014**

(54) **Broken rotor bar detection based on current signature analysis of an electric machine**

Detektion von gebrochenen Rotorwellen auf Basis einer Stromsignaturanalyse einer elektrischen Maschine

Détection de barre de rotor cassée par l'analyse de signature de courant d'une machine électrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.04.2013 US 201313858277**

(43) Date of publication of application:
**15.10.2014 Bulletin 2014/42**

(73) Proprietor: **GE Energy Power Conversion Technology Ltd**
**Rugby**
**Warwickshire CV21 1BU (GB)**

(72) Inventors:
 • **Neti, Prabhakar**
  **Niskayuna, NY 12309-1027 (US)**
 • **Grubic, Stefan**
  **Niskayuna, NY 12309-1027 (US)**

 • **Zhang, Pinjia**
  **Niskayuna, NY 12309-1027 (US)**

(74) Representative: **Serjeants LLP**
**Dock**
**75 Exploration Drive**
**Leicester, LE4 5NU (GB)**

(56) References cited:
**EP-A1- 2 565 658**      **US-A1- 2012 265 457**
**US-A1- 2012 319 722**

 • **AL AHMAR E ET AL: "Advanced signal processing techniques for fault detection and diagnosis in a wind turbine induction generator drive train: A comparative study", ENERGY CONVERSION CONGRESS AND EXPOSITION (ECCE), 2010 IEEE, IEEE, PISCATAWAY, NJ, USA, 12 September 2010 (2010-09-12), pages 3576-3581, XP031786933, ISBN: 978-1-4244-5286-6**

## Description

### BACKGROUND

The present invention relates, generally, to the field of monitoring electric machines, and, more particularly, to broken rotor bar detection in electric machines based on current signature analysis.

Electromechanical systems are widely used in variety of application areas such as power generation systems, manufacturing units, factories, electronic appliances, oil rigs, and the like. Electromechanical systems may experience variety of faults such as drive-train failure, bearing faults, broken rotor bars, and the like. It is of paramount importance to detect a fault in electric machines to ensure that losses caused by such faults are minimized to a great extent. Different techniques for fault detection that are employed at present include, but are not limited to, vibration and acoustic noise analysis, electromagnetic field monitoring and axial flow measurement, temperature measurement, infrared recognition, and spectral analysis of current in the machine.

Conventionally, the monitoring of faults in electric machines has been mainly performed using vibration signals. It has been observed that mechanical faults in rotor bars produce vibrations in radial rotor movement which in turn produce torque oscillations at the rotor mechanical rotating frequency. The monitoring and study of the rotor mechanical rotating frequency may lead to detecting mechanical faults associated with the rotor bars. However, condition monitoring using vibration signals has numerous disadvantages such as background noise due to external excitation motion, sensitivity to the installation position, the invasive nature of the measurement equipment, and proximity of frequencies of faulty operation with the operating frequency of the electromechanical machine.

Other condition monitoring techniques are based on the observation that the load torque oscillations cause the stator current to be phase modulated, whereby the stator current signature is analyzed for detecting mechanical perturbations due to fault. Such current monitoring techniques are receiving increased attention in the detection of mechanical faults in electric machines due to offering significant economic savings and simple implementation. However, certain fault current signatures, such as ones observed for broken bar faults, are usually subtle compared to the dominant components in the sampled stator current such as the supply fundamental harmonics, eccentricity harmonics, and slot harmonics. Unlike vibration monitoring, for which industry standards have been developed from long-time field experience, the field experience in stator current monitoring is limited, and significant difficulties exist. For example, the magnitude of fault signatures may vary at different applications given that the fault signatures in the stator current are already subtle. In addition, with broken bar fault detection, the frequency of broken bar current signatures is very close to the fundamental frequency of the electric machine. The aforementioned techniques are not always capable of distinguishing fault signatures from the normal operation signatures, when rotor bars of the electric machine are faulty.

EP 2565658 discloses a method of detecting faults in a wind turbine generator based on current signature analysis. The method includes acquiring a set of electrical signals representative of an operating condition of a generator. Further, the electrical signals are processed to generate a normalized spectrum of electrical signals. A fault related to a gearbox or bearing or any other component associated with the generator is detected based on analyzing the current spectrum. US 2012/0319722 discloses a method of detecting whether the stator in a vehicle alternator has a turn-to-turn short circuit. A limited Fast Fourier Transform (FFT) operation is carried out using a limited number of data points to reduce the sampling size and the complexity of the transformation. The FFT operation includes windowing. There exists a need for an improved method and system for monitoring the condition of rotor bars of an electric machine using current signature analysis.

### BRIEF DESCRIPTION

In one embodiment, a method for detecting broken bar faults in an electric machine as set out in claim 1 is provided.

In another embodiment, a system for detecting broken bar faults in an electric machine as set out in claim 7 is provided.

### DRAWINGS

Other features and advantages of the present disclosure will be apparent from the following more detailed description of the preferred embodiment, taken in conjunction with the accompanying drawings which illustrate, by way of example, the principles of certain aspects of the disclosure.

FIG. 1 illustrates an electromechanical machine (EMM) according to one embodiment;

FIG. 2 is a block diagram of a system for detection of rotor bar faults in the EMM illustrated in FIG. 1, according to one embodiment;

FIG. 3 is a schematic representation of an exemplary waveform of electrical signals acquired from the EMM in FIG. 1 in the frequency domain in accordance with an embodiment; and

FIG. 4 is a flow chart representing steps involved in an exemplary method of detecting rotor bar faults in the EMM of FIG. 1, according to one embodiment.

DETAILED DESCRIPTION

Reference will be made below in detail to exemplary embodiments of the invention, examples of which are illustrated in the accompanying drawings. Wherever possible, the same reference numerals used throughout the drawings refer to the same or like parts.

A spectrum analysis based technique for high sensitivity detection of broken rotor bar faults in an electromechanical machine (EMM) is described herein. The technique provides for differentiating a faulty EMM rotor bar's condition from normal or admissible conditions based on possibly subtle changes in the magnitude of electric signatures received from the EMM. The dominant components in electric signals received from a typical electromechanical machine are the supply fundamental and harmonics, the eccentricity harmonics, the slot harmonics, the saturation harmonics, and other components from unknown sources including environmental noise. Since such dominant components exist before and after the presence of rotor bar fault, a large body of the information they carry is not related to the rotor bar fault. In this sense, they are basically "noise" to the EMM fault detection problem.

The frequency of the dominant components can be typically determined from the supply frequency, rotor speed, and machine structure. If rotor bar fault signatures are considered as signal and those dominant components are considered as noise, then the rotor bar fault detection problem is essentially a low signal-to-noise ratio problem. Further, since the frequency of the signal may not be predictable, the signal and noise tend to have almost identical frequencies. It is hence important to remove the noise components to discover the fault signature. The noise components and normal operating condition signatures are thus separated from one another, and then the normal operating condition signatures are cancelled by their estimates in a real-time fashion. By doing so, the remaining components are more related to the rotor bar faults.

One embodiment of the invention provides for systematically and dynamically eliminating the contributions of the symmetrical or useful components of an electrical signal of a multi-phase system such as current, voltage, or power. Such elimination allows the "distortions" of the electrical signals caused by broken rotor bars or other rotor related faults to get highlighted in the AC spectrum and thus make their detection much easier. More specifically, the method involves eliminating symmetrical components from the electrical signals by squaring the data points of the electrical signal of each of the multiple phases and summing them. The squaring of the instantaneous values of an electrical signal "folds" or adds all the symmetrical component contributions into an equivalent DC signal. Further, discontinuities from the resulting set of data points from the electrical signals are removed by multiplying the data points of the electrical signal with a window function. The resultant weighted representation of the electrical signals is then analyzed in the frequency domain by utilizing analysis modes such as a Fast Fourier Transform (FFT). Thus, by such elimination of all symmetrical terms, the effects of abnormalities, for example the presence of a broken rotor bar, stand out in the AC spectrum, as they do not have to compete with the useful or symmetrical components. Thus, the resulting AC spectrum that can be ascribed only to an abnormal condition is analyzed with a much higher level of sensitivity.

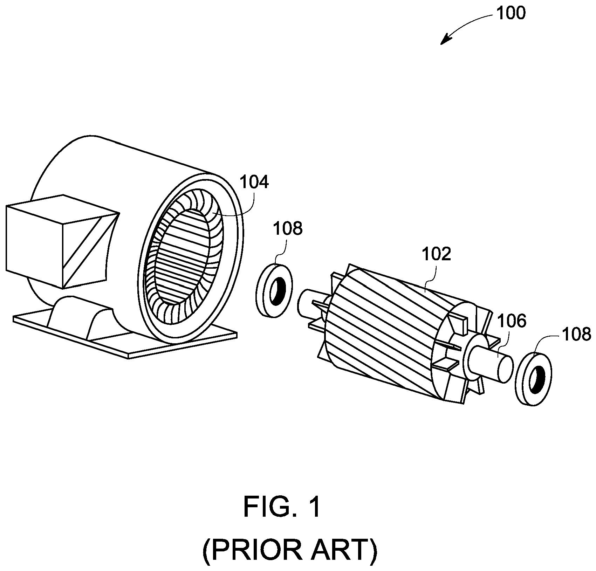

Referring to FIG. 1, a prior-art electromechanical machine (EMM). According to the illustrated embodiment, the EMM 100 is an induction motor. The EMM 100 includes a rotor assembly 102, a stator assembly 104, a main shaft 106, and a main bearing 108.

A controller (not shown in FIG. 1) may be used for monitoring and controlling the operation of the EMM 100 in response to various inputs in accordance with embodiments of the present invention. For example, a controller coupled with the EMM 100 may be configured to control operations of the machine based on inputs received from sensors configured to acquire data pertaining to operating conditions of the EMM 100. According to certain embodiments, the electrical signal sensors may be current and voltage sensors for acquiring current and voltage data pertaining to the EMM 100. For example, the current sensor senses current data from one or more of the multiple phases of the EMM. More specifically, in the case of the EMM comprising a 3-phase induction motor, the current and voltage sensors sense the current and voltage data from the three phases of the 3-phase induction motor. While certain embodiments of the present invention will be described with respect to a multi-phase induction motors, other embodiments of the present invention can be applied to other multi-phase electromechanical machines.

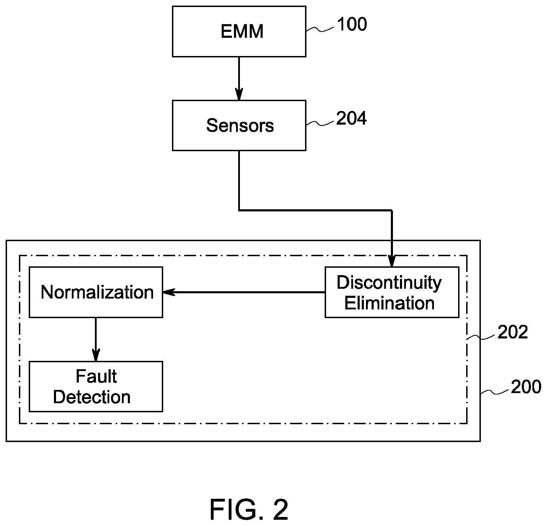

Embodiments of the present invention describe a system for detection of broken bar faults in an electromechanical machine, such as the EMM 100. The controller configured for detection includes a processing sub-system for detecting the presence of a faulty condition of various components, including rotor bars, within the EMM assembly. The controller, communicably coupled with the processing sub-system, will be discussed in greater detail with respect to FIG. 2. When broken bar analysis is required to be performed on the EMM 100, it is useful to measure the effect of the broken rotor bars on the current flowing in the EMM 100. The presence of the broken bar in the EMM 100 leads to reduction in the torque of the rotor thus leading to increasing reliance on other rotor bars of the EMM 100 to provide the desired current. The increased dependence on other rotor bars leads to an increase in the rate of deterioration of the other rotor bars and thus leads to an overall effect on the EMM 100's performance.

In one embodiment of the invention, the current and voltage sensors respectively detect stator current data from the stator assembly 104 of the EMM 100. The current data and voltage data acquired from the sensors is communicated to the controller, for further processing and analysis. The analysis includes performing current signature analysis (CSA) to detect faults within the EMM 100. According to an embodiment of the invention, the processing sub-system of the controller is configured to eliminate the contributions of the symmetrical or useful components of an electrical signal so that only unbalanced components in the signal relating to fault will show up as AC quantities in the AC spectrum. Particularly, the processing sub-system is programmed to remove such non-fault related symmetrical or useful components by squaring the instantaneous values of the current data for each of the multiple phases and summing the squared values. As a result, the non-fault related symmetrical components are transformed to DC quantities while the fault related asymmetrical components of the current signal show up in the AC spectrum at twice the frequency.

Referring now to FIG. 2, a detailed block diagram of the controller is shown. As stated with respect to FIG. 1, controller 200 includes a processing sub-system 202. The processing sub-system 202 is connected to a sensor bank 204 and receives current and voltage data for each phase of the electric machine 110.

The processing sub-system 202 functions as a separation system configured to eliminate discontinues from the electric signals received from the sensor bank 204, and further to systematically and dynamically eliminate the contributions of the symmetrical or useful components of an electrical signal of a multi-phase system such as current or voltage or power. Such elimination allows the "distortions" of the electrical signals caused by machine 100 asymmetry and/or fault to get highlighted in the AC spectrum. In other words, the processing sub-system 202 is configured to treat the fundamental frequency components as noise and the remaining frequency components as fault related components. Dynamically eliminating the noise components from continuously acquired stator current components yields purely fault related components which are injected into the stator current by the electromechanical faults. For example, the processing sub-system 202 may be programmed to remove discontinuities around the fundamental frequency, and further eliminate low frequency harmonics (especially the base frequency component) from the measured stator current data. The removal of the low frequency harmonics from the measured stator current data may greatly improve the analog-to-digital conversion resolution and SNR, as the 60 Hz fundamental frequency has a large magnitude in the frequency spectrum of the current signal.

To provide accurate noise cancellation in the stator current, the processing sub-system 202 is configured to dynamically eliminate the non-fault related, balanced components i.e., the noise components in the stator current. The processing sub-system 202 is configured compute a square of instantaneous values of the data points on the electrical signal (current, voltage, power, etc.) of each of the multiple phases and sum the squared instantaneous values, according to equations (1) and (2), so that the symmetrical or balanced (and normally useful) components get transformed into an equivalent DC quantity and any unbalanced, fault-related components appear at twice the frequency in the AC spectrum.

$$I = Ia^2 + Ib^2 + \ldots + In^2 \qquad\qquad ---- (1)$$

$$V = Va^2 + Vb^2 + \ldots + Vn^2 \qquad\qquad ---- (2)$$

In order to dynamically further eliminate noise components in the stator current spectrum, the processing sub-system 202 is configured compute a weighted representation of the squared values. The weighted representation of the stator current is calculated by multiplying each data point with a window function.

According to one embodiment, the window function acts as a filter that filters values pertaining to a particular frequency from the electrical signals. In case of broken rotor bars, according to one embodiment, for detection of faults, amplitudes at frequencies close to the fundamental frequency (such as 60Hz) are analyzed. The window function is thus selected such that data points in the vicinity of the fundamental frequency are retained and utilized for analysis. According to one embodiment, the window function is at least one of a Hanning window, or a Hamming window, or a rectangular window, or a Bohman window. In one embodiment, the rectangular window is utilized to obtain the weighted representation of the electrical signals. The rectangular window provides for a low dynamic range which allows for elimination of discontinuities from the electrical signals acquired from the EMM 100.

The processing sub-system 202 is further configured to normalize the weighted representation of the electrical signals by performing at least one of a Fast Fourier Transform (FFT), or a time-frequency analysis, or a multimodal resolution analysis on the weighted representation, according to equations (3) and (4) in order to decompose the non-fault related components in the electrical signal into an equivalent DC quantity while rendering the fault related components in the AC spectrum at "x" times the frequency in the frequency domain.

$$FFT\ (I) = x*fI \qquad\qquad ---- (3)$$

$$FFT\ (V) = x*fV \qquad\qquad ---- (4)$$

wherein, x is a multiple determining a spread of the frequency spectrum of the current and voltage electrical signals.

The frequency spectrum arrived at, from equations 3 and 4, is utilized to analyze the health of the EMM 100 by the processing-subsystem 200. The presence of electrical signals at bins other than the ones representing the fundamental frequency of operation of the electric machine assembly 100 is considered as an indicator of faults in the EMM 100, according to one embodiment.

While detecting rotor bar faults, the processing sub-system 202 also compares electrical signals obtained from the sensor bank 204 with thresholds defined for abnormal/faulty operations of the EMM 100. Specifically, thresholds can be computed such that a measurement frequency falling outside the threshold indicates a deteriorated/abnormal rotor bar condition. One approach to compute the threshold may be to find the highest level of faulty measurements in the electrical signals during normal conditions and set this value as the threshold. In another embodiment, to determine the threshold, baseline data of the EMM 100 is acquired by the sensors. The baseline data represents the EMM 100 normal operations with no mechanical faults. The baseline current data associated with healthy rotor bar conditions may include a set of stator current data for each of the multiple phases that are acquired, shortly after the installation of the EMM 100. In an example, the baseline stator electrical signals are acquired during the initial operation of the EMM assembly 100, i.e., the first time the EMM assembly 100 is run after the EMM assembly 100 is installed. The stator current data thus acquired ensures that no broken rotor bar related fluctuations are included in the acquired current data. The processing sub-system 202 receives the current and voltage data from the sensors and computes the baseline measurements for current and voltage according to equations (5) and (6) below,

$$Ibaseline = Ia\text{-}baseline^2 + Ib\text{-}baseline^2 + ... + In\text{-}baseline^2 \qquad\qquad ---- (5)$$

$$Vbaseline = Va\text{-}baseline^2 + Vb\text{-}baseline^2 + ... + Vn\text{-}baseline^2 \qquad\qquad ---- (6)$$

wherein Ibaseline, is the baseline stator current data measured during healthy machine conditions; Ia-baseline is the baseline stator current data for the first phase; Ib-baseline is the baseline stator current data for the second phase; In-baseline is the baseline stator current data for the nth phase; Vbaseline is the baseline stator voltage data measured during healthy machine conditions; Va-baseline is the baseline stator voltage data for the first phase; Vb-baseline is the baseline stator voltage data for the second phase; andVn-baseline is the baseline stator voltage data for the nth phase.

Thus, the baseline current (I) and voltage (V) data is a sum of the squares of the instantaneous values of current and voltage signal of each of the multiple phases. The processing sub-system 202 is further configured to perform Fast Fourier Transform (FFT) on the baseline stator current and voltage values, according to equations (3) and (4) in order to decompose the non-fault related components in the current signal (I) into an equivalent DC quantity while rendering the fault related components in the AC spectrum at "x" times the frequency in the frequency domain. Since all the components in the stator current at a healthy condition are noise, no fault information is embedded in the AC spectrum during baseline measurements. Therefore, when the fault develops, only the noise components show up in the AC spectrum at x times the frequency.

In an ideal situation, assuming that the EMM 100 is operating normally with no mechanical faults, the resulting stator current and voltage data will have the non-fault related components, i.e. the balanced components, eliminated and with no fault-related components in the AC spectrum. The resulting stator current and voltage data will form the baseline data during fault detection. The processing sub-system 202 may store the baseline measurements in a memory for use during rotor 102 fault analysis and detection.

During detection of fault with the assembly 100, the procesing sub-system 202 receives the current and voltage data from the sensors 204. The processing sub-system 202 is configured to eliminate discontinuities in the acquired data by generating a weighted representation of the electrical signals. The weighted representation is obtained by applying a window function to data points of the acquired signals. The processing sub-system 202 is further configured to perform a Fast Fourier Transform (FFT) on the weighted representation of the electric signals, according to equations (3) and (4) in order to decompose the non-fault related components in the weighted current signal (I) into an equivalent DC quantity while rendering the fault related components in the AC spectrum at "x" times the frequency in the frequency domain.

The processing sub-system 202 may then compare the magnitudes and phases of the weighted AC quantities for the voltage and current with the baseline measurements for voltage and current. Based on the comparison, any deviation of the weighted quantities from the baseline measurements may indicate a fault in rotor components of the EMM assembly 100, such as a rotor bar The results of the comparison may be stored in the memory associated with the processing sub-system 202 for further analysis such as the frequency of faults, the time of occurrence of faults, frequency of failure of the rotor bars, etc.

According to one embodiment, the threshold for stator current measurement is acquired from the baseline data, by using equation 7:

$$\text{Threshold} = \text{Mean(baseline data)} + k*\text{Standard Deviation(baseline data)} ----- (7)$$

wherein k is a constant that is calculated based on a sampling rate of the electrical signals acquired from the EMM 100.

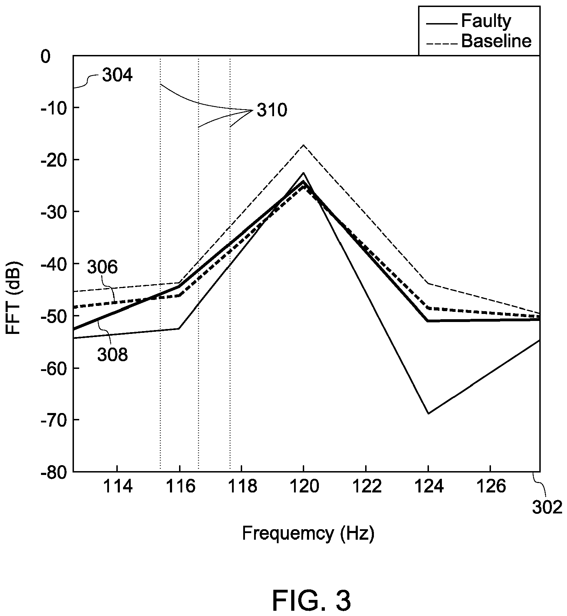

A waveform of a sample stator output current in the frequency domain is shown in FIG. 3. The x-axis 302 represents frequency in Hz, and the y-axis 304 represents gain in dB. Curve 306 represents electrical signals under normal conditions; while curve 308 represents electrical signals under a faulty condition where at least one rotor bar of the assembly 100 has broken. Further, lines 310 indicate thresholds defined for determination of the faulty condition. According to one embodiment, the threshold is determined based on equation 11. For example, the threshold is determined by inputting different values of k in equation 11 based on a number of samples that define the electrical signal till a particular position along the curve 308.

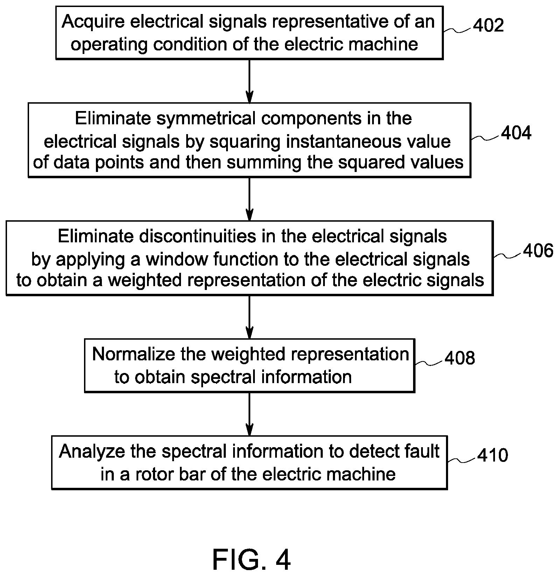

In one embodiment, the present invention is applied to a doubly fed induction motor, where faults in the rotor bar can lead to changes in stator current and voltages. The method for determination of faults in the rotor of the doubly fed induction motor is illustrated in Fig. 4. At 402, the method includes acquiring electrical signals, for example, stator output current signals using one or more sensors. The one or more sensors may be condition based monitoring (CBM) sensors. In an example, the electrical signals are current signals that correspond to an operating condition of the motor such as a faulty operating condition. The method further includes, at step 404, eliminating symmetrical components in the electrical signals by squaring instantaneous value of data points and then summing the squared values. Further, in step 406 discontinuities are eliminated from the electrical signals by generating a weighted representation of the squared values. The weighted representation is generated by utilizing a window function for each data point. The window function, according to some embodiments, may be at least one of rectangular window, hamming window, hanning window, or bohman window. Further, at step 408, the weighted representation of electrical signals is processed based on Fast Fourier Transforms, time frequency analysis, or multimodal resolution analysis, or combinations thereof to provide a normalized spectrum of electrical signals. In step 410, the normalized spectral information is provided to the processing sub-system for feature extraction and for performing spectral reinforcement based conclusions. In step 410, a fault related to the rotor bars is detected when the current signature deviates from a determined threshold value.

Certain embodiments contemplate methods, systems and computer program products on any machine-readable media to implement functionality described above. Certain embodiments may be implemented using an existing computer processor, or by a special purpose computer processor incorporated for this or another purpose or by a hardwired and/or firmware system, for example. Certain embodiments include computer-readable media for carrying or having computer-executable instructions or data structures stored thereon. Such computer-readable media may be any available media that may be accessed by a general purpose or special purpose computer or other machine with a processor. By way of example, such computer-readable media may comprise RAM, ROM, PROM, EPROM, EEPROM, Flash, CD-ROM or other optical disk storage, magnetic disk storage or other magnetic storage devices, or any other medium which can be used to carry or store desired program code in the form of computer-executable instructions or data structures and which can be accessed by a general purpose or special purpose computer or other machine with a processor. Combinations of the above are also included within the scope of computer-readable media. Computer-executable instructions comprise, for example, instructions and data which cause a general purpose computer, special purpose computer, or special purpose processing machines to perform a certain function or group of functions. In other embodiments, networked environment may be used to utilize computational abilities of networked computers. Logical connections such as a local area network (LAN) and a wide area network (WAN), presented here by way of example and not limitation, can be used to establish the networked environment. Embodiments of the disclosure may also be practiced in distributed computing environments where tasks are performed by local and remote processing devices that are linked (either by hardwired links, wireless links, or by a combination of hardwired or wireless links) through a communications network. In a distributed computing environment, program modules may be located in both local and remote memory storage devices.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. While the dimensions and types of materials described herein are intended to define the parameters of the invention, they are by no means limiting and are exemplary embodiments. Many other embodiments will be apparent to those of ordinary skill in the art upon reviewing the above description. The scope of the invention should, therefore, be determined with reference to the appended claims.

In the appended claims, the terms "including" and "in which" are used as the plain-English equivalents of the respective terms "comprising" and "wherein." Moreover, in the following claims, the terms "first," "second," etc. are used merely as labels, and are not intended to impose numerical or positional requirements on their objects.

As used herein, an element or step recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising," "including," or "having" an element or a plurality of elements having a particular property may include additional such elements not having that property.

Since certain changes may be made in the above-described system for broken rotor bar detection based on current signature analysis of an electric machine, without departing from the spirit and scope of the invention herein involved, it is intended that all of the subject matter of the above description or shown in the accompanying drawings shall be interpreted merely as examples illustrating the inventive concept herein and shall not be construed as limiting the invention.

## Claims

1. A method for detecting faults in a rotor bar of an electric machine (100) having multiple phases, the method comprising:

   acquiring (402) electrical signals representative of an operating condition of the electric machine (100) for each phase of the electric machine;
   eliminating (404) symmetrical components from the electrical signals by squaring an instantaneous value of a data point of the electrical signals for each phase of the electric machine (100) and summing the squared instantaneous values;
   selecting a window function based on a proximity of the electrical signals to frequencies pertaining to faults of the rotor bar in the electric machine (100) and a frequency pertaining to a normal operation of the electric machine (100);
   eliminating (406) discontinuities in the electrical signals by applying the window function to each sum of the squared instantaneous values to obtain a weighted representation of the electrical signals;
   normalizing (408) the weighted representation to obtain spectral information utilizing at least one of a Fast Fourier Transform, time frequency analysis, and multimodal resolution analysis; and
   analyzing (410) the spectral information to detect fault in the rotor bar.

2. A method according to claim 1, wherein the electrical signals comprise current signals, or voltage signals, or a combination of current and voltage signals.

3. A method according to claim 1, wherein the window function comprises at least one of a rectangular window, a Hanning window, a Hamming window, and a Bohman window.

4. A method according to any preceding claim, wherein normalizing the weighted representation to extract spectral information further comprises extracting asymmetrical components that appear in the weighted result.

5. A method according to any preceding claim further comprising:

   acquiring a second set of electrical signals representative of a non-faulty operating condition of the electric machine (100); and
   determining a threshold for faulty operation of the broken bar of the electric machine (100) based on a mean of amplitude of the second set of electrical signals.

6. A method according to claim 5, further comprising comparing the electrical signals representative of faulty operation of the electric machine (100) with the threshold to determine the fault in the rotor bars of the electric machine (100).

7. A system for detecting faults in a rotor bar of an electric machine (100) having multiple phases, the system comprising:

one or more sensors (204) for acquiring electrical signals representative of an operating condition of the electric machine (100) for each phase of the electric machine;
a controller (200) comprising:
a processing sub-system (202) configured to:

eliminate symmetrical components from the electrical signals by squaring an instantaneous value of each data point of the electrical signals for each phase of the electric machine (100)and summing the squared instantaneous values;
select a window functon based on a proximity of the electrical signals to frequencies pertaining to faults of the rotor bar in the electric machine (100) and a frequency pertaining to a normal operation of the electric machine (100);
eliminate discontinuities in the electrical signal to obtain a weighted representation of the electrical signals by applying the window function to each sum of the squared instantaneous values of the electrical signals;
normalize the weighted representation to extract spectral information utilizing at least one of a Fast Fourier Transform, time frequency analysis, and multimodal resolution analysis; and
detecting one or more faults in the rotor bar based on analysis of the extracted spectral information.

8. A system according to claim 7, wherein said processing sub-system (202) is further configured to extract asymmetrical components that appear in the weighted result during abnormal operating conditions.

9. A system according to claim 7 or claim 8, wherein the processing sub-system (202) is configured to apply at least one of a rectangular window, a hanning window, and a Hamming window on the electric signals obtained from the electric machine (100).

**Patentansprüche**

1. Verfahren zur Erkennung von Fehlern in einem Läuferstab einer elektrischen Maschine (100), die mehrere Phasen aufweist, wobei das Verfahren aufweist:

Erfassen (402) elektrischer Signale, die einen Betriebszustand der elektrischen Maschine (100) für jede Phase der elektrischen Maschine repräsentieren;
Eliminieren (404) symmetrischer Komponenten aus den elektrischen Signalen durch Quadrieren eines Momentanwertes eines Datenpunktes der elektrischen Signale für jede Phase der elektrischen Maschine (100) und Summieren der quadrierten Momentanwerte;
Auswählen einer Fensterfunktion auf der Basis einer Nähe der elektrischen Signale zu Frequenzen, die zu Fehlern des Läuferstabs in der elektrischen Maschine (100) gehören, und einer Frequenz, die zu einem Normalbetrieb der elektrischen Maschine (100) gehört;
Eliminieren (206) von Diskontinuitäten in den elektrischen Signalen durch Anwenden der Fensterfunktion auf jede Summe der quadrierten Momentanwerte, um eine gewichtete Darstellung der elektrischen Signale zu erhalten;
Normalisieren (408) der gewichteten Darstellung, um Spektralinformationen zu erhalten, unter Verwendung wenigstens einer von einer schnellen Fourier-Transformation, einer Zeit-Frequenz-Analyse und einer multimodalen Auflösungsanalyse; und
Analysieren (410) der Spektralinformationen, um einen Fehler in dem Läuferstab zu erkennen.

2. Verfahren nach Anspruch 1, wobei die elektrischen Signale Stromsignale oder Spannungssignale oder eine Kombination aus Strom- und Spannungssignalen aufweisen.

3. Verfahren nach Anspruch 1, wobei die Fensterfunktion wenigstens eines von einem Rechteck-Fenster, einem Hanning-Fenster, einem Hamming-Fenster und einem Bohman-Fenster aufweist.

**4.** Verfahren nach einem beliebigen vorhergehenden Anspruch, wobei das Normalisieren der gewichteten Darstellung, um Spektralinformationen zu extrahieren, ferner ein Extrahieren asymmetrischer Komponenten, die in dem gewichteten Ergebnis erscheinen, aufweist.

**5.** Verfahren nach einem beliebigen vorhergehenden Anspruch, das ferner aufweist:

Erfassen eines zweiten Satzes elektrischer Signale, die einen fehlerfreien Betriebszustand der elektrischen Maschine (100) repräsentieren; und
Bestimmen einer Schwelle für einen fehlerbehafteten Betrieb des defekten Stabes der elektrischen Maschine (100) auf der Basis eines Mittelwertes der Amplitude des zweiten Satzes elektrischer Signale.

**6.** Verfahren nach Anspruch 5, das ferner ein Vergleichen der elektrischen Signale, die einen fehlerhaften Betrieb der elektrischen Maschine (100) repräsentieren, mit dem Schwellenwert aufweist, um den Fehler in dem Läuferstab der elektrischen Maschine (100) festzustellen.

**7.** System zum Erkennen von Fehlern in einem Läuferstab einer elektrischen Maschine (100), die mehrere Phasen aufweist, wobei das System aufweist:

einen oder mehrere Sensoren (204) zur Erfassung elektrischer Signale, die einen Betriebszustand der elektrischen Maschine (100) für jede Phase der elektrischen Maschine repräsentieren;
eine Steuereinrichtung (200), die aufweist:
ein Verarbeitungsuntersystem (202), das eingerichtet ist, um:

symmetrische Komponenten aus den elektrischen Signalen durch Quadrieren eines Momentanwertes jedes Datenpunktes der elektrischen Signale für jede Phase der elektrischen Maschine (100) und Summieren der quadrierten Momentanwerte zu eliminieren;
eine Fensterfunktion basierend auf einer Nähe der elektrischen Signale zu Frequenzen, die zu Fehlern des Läuferstabs in der elektrischen Maschine (100) gehören, und einer Frequenz, die zu einem Normalbetrieb der elektrischen Maschine (100) gehört, auszuwählen;
Diskontinuitäten in dem elektrischen Signal zu eliminieren, um eine gewichtete Darstellung der elektrischen Signale zu erhalten, durch Anwenden der Fensterfunktion auf jede Summe der quadrierten Momentanwerte der elektrischen Signale;
die gewichtete Darstellung zu normalisieren, um Spektralinformationen zu extrahieren, unter Verwendung wenigstens einer von einer schnellen Fourier-Transformation, einer Zeit-Frequenz-Analyse und einer multimodalen Auflösungsanalyse; und
einen oder mehrere Fehler in dem Läuferstab auf der Basis einer Analyse der extrahierten Spektralinformationen zu erkennen.

**8.** System nach Anspruch 7, wobei das Verarbeitungsuntersystem (202) ferner eingerichtet ist, um asymmetrische Komponenten zu extrahieren, die in dem gewichteten Ergebnis während anomaler Betriebsbedingungen erscheinen.

**9.** System nach Anspruch 7 oder Anspruch 8, wobei das Verarbeitungsuntersystem (202) eingerichtet ist, um wenigstens eines von einem Rechteck-Fenster, einem Hanning-Fenster und einem Hamming-Fenster auf die elektrischen Signale, die von der elektrischen Maschine (100) erhalten werden, anzuwenden.

**Revendications**

**1.** Procédé de détection de défauts dans une barre de rotor d'une machine électrique (100) ayant plusieurs phases, le procédé comprenant les étapes suivantes :

acquérir (402) des signaux électriques représentatifs d'un état de fonctionnement de la machine électrique (100) pour chaque phase de la machine électrique ;
éliminer (404) les composantes symétriques des signaux électriques en élevant au carré une valeur instantanée d'un point de donnée des signaux électriques pour chaque phase de la machine électrique (100) et en additionnant les valeurs instantanées élevées au carré ;
sélectionner une fonction de fenêtre basée sur une proximité des signaux électriques avec des fréquences se rapportant à des défauts de la barre de rotor dans la machine électrique (100) et une fréquence se rapportant à un fonctionnement normal de la machine électrique (100) ;

éliminer (406) les discontinuités des signaux électriques en appliquant la fonction de fenêtre à chaque somme des valeurs instantanées élevées au carré pour obtenir une représentation pondérée des signaux électriques ;

normaliser (408) la représentation pondérée pour obtenir une information spectrale en utilisant au moins une fonction parmi une transformée de Fourier rapide, une analyse temps-fréquence et une analyse de résolution multimodale ; et

analyser (410) l'information spectrale pour détecter un défaut dans la barre de rotor.

2. Procédé selon la revendication 1, dans lequel les signaux électriques comprennent des signaux d'intensité, ou des signaux de tension, ou une combinaison de signaux d'intensité et de tension.

3. Procédé selon la revendication 1, dans lequel la fonction de fenêtre comprend au moins un élément parmi une fenêtre rectangulaire, une fenêtre de Hanning, une fenêtre de Hamming et une fenêtre de Bohman.

4. Procédé selon l'une quelconque des revendications précédentes, dans lequel la normalisation de la représentation pondérée pour extraire une information spectrale comprend en outre l'extraction des composantes asymétriques qui apparaissent dans le résultat pondéré.

5. Procédé selon l'une quelconque des revendications précédentes, comprenant en outre les étapes suivantes :

acquérir un deuxième ensemble de signaux électriques représentatifs d'un état de fonctionnement sans défaut de la machine électrique (100) ; et

déterminer un seuil pour le fonctionnement défectueux de la barre cassée de la machine électrique (100) basé sur une moyenne d'amplitude du deuxième ensemble de signaux électriques.

6. Procédé selon la revendication 5, comprenant en outre l'opération consistant à comparer les signaux électriques représentatifs d'un fonctionnement défectueux de la machine électrique (100) avec le seuil pour déterminer le défaut dans les barres de rotor de la machine électrique (100).

7. Système permettant de détecter des défauts dans une barre de rotor d'une machine électrique (100) ayant plusieurs phases, le système comprenant :

un ou plusieurs capteurs (204) pour acquérir des signaux électriques représentatifs d'un état de fonctionnement de la machine électrique (100) pour chaque phase de la machine électrique ;

un contrôleur (200) comprenant :

un sous-système de traitement (202) configuré pour :

éliminer les composantes symétriques des signaux électriques en élevant au carré une valeur instantanée de chaque point de donnée des signaux électriques pour chaque phase de la machine électrique (100) et en additionnant les valeurs instantanées élevées au carré ;

sélectionner une fonction de fenêtre basée sur une proximité des signaux électriques avec des fréquences se rapportant à des défauts de la barre de rotor dans la machine électrique (100) et une fréquence se rapportant à un fonctionnement normal de la machine électrique (100) ;

éliminer les discontinuités des signaux électriques pour obtenir une représentation pondérée des signaux électriques en appliquant la fonction de fenêtre à chaque somme des valeurs instantanées des signaux électriques élevées au carré ;

normaliser la représentation pondérée pour extraire une information spectrale en utilisant au moins une fonction parmi une transformée de Fourier rapide, une analyse temps-fréquence et une analyse de résolution multimodale ; et

détecter un ou plusieurs défauts dans la barre de rotor en se basant sur une analyse de l'information spectrale extraite.

8. Système selon la revendication 7, dans lequel ledit sous-système de traitement (202) est configuré en outre pour extraire les composantes asymétriques qui apparaissent dans le résultat pondéré pendant des conditions de fonctionnement anormales.

9. Système selon la revendication 7 ou 8, dans lequel le sous-système de traitement (202) est configuré pour appliquer au moins un élément parmi une fenêtre rectangulaire, une fenêtre de Hanning et une fenêtre de Hamming aux signaux électriques provenant de la machine électrique (100).

FIG. 1
(PRIOR ART)

FIG. 2

FIG. 3

Acquire electrical signals representative of an operating condition of the electric machine ⌇402

Eliminate symmetrical components in the electrical signals by squaring instantaneous value of data points and then summing the squared values ⌇404

Eliminate discontinuities in the electrical signals by applying a window function to the electrical signals to obtain a weighted representation of the electric signals ⌇406

Normalize the weighted representation to obtain spectral information ⌇408

Analyze the spectral information to detect fault in a rotor bar of the electric machine ⌇410

FIG. 4

**EP 2 790 028 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2565658 A
- US 20120319722 A